# EUROPEAN PATENT SPECIFICATION

(11) **EP 4 220 686 B1**
(45) Date of publication and mention of the grant of the patent: **10.07.2024**
(21) Application number: 22154292.1
(22) Date of filing: 31.01.2022
(51) Int. Cl.: H01L 21/20

(54) **METHOD FOR DEPOSITING A STRAIN RELAXED GRADED BUFFER LAYER OF SILICON GERMANIUM ON A SURFACE OF A SUBSTRATE**
VERFAHREN ZUR ABSCHEIDUNG EINER SPANNUNGSRELAXIERTEN GRADIERTEN PUFFERSCHICHT AUS SILIZIUM-GERMANIUM AUF EINER OBERFLÄCHE EINES SUBSTRATS
PROCÉDÉ DE DÉPÔT D'UNE COUCHE TAMPON À GRADIENT DE CONTRAINTE RELAXÉ EN SILICIUM-GERMANIUM SUR UNE SURFACE D'UN SUBSTRAT

(43) Date of publication of application: 02.08.2023
(73) Proprietor: Siltronic AG, 81677 München (DE)
(72) Inventor: Becker, Lucas, 94436 Simbach (DE); Storck, Peter, 84489 Burghausen (DE)
(74) Representative: Staudacher, Wolfgang

(56) References cited:
- WO-A1-01/22482
- US-A1- 2003 215 990
- US-A1- 2003 230 233

## Description

The invention is directed to a method for depositing a strain relaxed graded buffer layer of silicon germanium on a surface of a substrate, the surface consisting of silicon and the buffer layer having an increasing content of germanium up to a final content.

### Prior Art / Problems

Silicon germanium or briefly SiGe is a semiconductor comprising both silicon and germanium according to the formula Si₁₋ₓGeₓ, wherein 0 < x < 1. Accordingly, a germanium content of 25 % Ge is represented by the formula Si_{0.75}Ge_{0.25}.

Due to lattice mismatch between silicon and silicon germanium, a heteroepitaxial Si₁₋ₓGeₓ buffer layer grows strained on a Si substrate up to a critical thickness, where the strain energy becomes high enough, that it is favorable to form misfit dislocations (and their respective threading dislocation segment, that penetrate the surface of the layer) that relax the epitaxial layer and reduce strain. Relaxed SiGe buffer layers may be used to deposit strained silicon thereon for manufacturing electronic devices having improved properties. The quality of relaxed SiGe buffer layers is largely determined by the Threading Dislocation Density (TDD).

WO 2004 084 268 A2 and US 2007 0 077 734 A1, each discloses a method for depositing an epitaxial germanium-containing layer on a silicon single crystal structure.

US 2015 0 318 355 A1 discloses the manufacturing of a strain-relieved buffer comprising a first and a second SiGe layer, wherein a TDD of the second SiGe layer is less than 1 × 10³ / cm².

Further prior art is known from WO 01/22482.

The object of the invention is the provision of a method for depositing a strain relaxed graded buffer layer of silicon germanium on a surface of a substrate that is comparatively easy to perform and that provides access to a TDD which is comparatively low.

Provided is a method for depositing a strain relaxed graded buffer layer of silicon germanium on a surface of a substrate, the surface consisting of silicon and the buffer layer having an increasing content of germanium up to a final content, the method comprising
conducting GeCl₄ and SiH₂Cl₂ during a first and a second stage over the surface of the substrate at a deposition temperature of not less than 800 °C_{;}
growing the buffer layer with a grade rate that is less than 10 % Ge / µm; and growing the buffer layer with a growth rate that is not less than 0.1 µm / min during the first stage and that is less than 0.1 µm / min during the second stage.

### Description

The following considerations and findings help to understand the invention. Relaxation by misfit dislocations can be achieved by two mechanisms, that influence the final TDD in a different way:
(i) nucleation and glide of new dislocation loops; each new loop generates 2 threading dislocations, which increase the final TDD.
(ii) glide and elongation of existing dislocation loops; pre-existing loops glide and relax the buffer layer, the TDD is not increased.

A SiGe buffer layer with low TDD has a low number of half-loops that glided far within the buffer layer forming long misfit dislocation segments, whereas a buffer layer with high TDD has a high number of half-loops that have only short misfit dislocation segments. The final TDD thus is a result of the balance between (i) and (ii), namely how many half-loops are generated and how long those are able to glide unhindered.

The balance of the two mechanisms (i) and (ii) is of differing importance in different phases of the buffer layer growth. In the early stage of the buffer layer growth no dislocations are present within the buffer layer, new loops have to be nucleated to relax the buffer layer, thus (i) is the dominating mechanism. During continued grading it is preferred that (ii) is the dominating mechanism to receive a low TDD.

Accordingly, the growth conditions employed during the two phases of buffer growth have to be optimized individually, which is the core of this invention. Different growth rates are used in different stages of buffer layer growth to generate a low final TDD of the relaxed buffer layer.

During a first stage of the deposition of the SiGe buffer layer the growth rate that is not less than 0.1 µm / min, whereas the growth rate is less than 0.1 µm / min during a second stage. Preferably, the growth rate is not less than 0.3 µm / min and not more than 0.6 µm / min during the first stage and not less than 0.01 µm / min and not more than 0.095 µm/ min during the second stage.

The grade rate in terms of increase of content of germanium per thickness of the buffer layer is less than 10 % Ge / µm during both, the first and the second stage of the deposition process.

The higher growth rate during the first stage ensures optimum conditions in the nucleation phase of the relaxation process, which results in a low base TDD. This TDD is kept low during continued grading by employing a very low growth rate and grading rate in the second stage.

Preferably, the first stage ends not later than when about 1/3 of the final content of Ge has been reached. The second stage ends when the final content of Ge has been reached.

According to an embodiment of the invention, the germanium final content is not less than 2% Ge and not more than 90% Ge. According to a preferred embodiment, the final content is 25 % Ge and the first stage ends when a content of 8 % Ge has been reached.

The SiGe buffer layer is grown by using a CVD method (chemical vapor deposition) with GeCl₄ and SiH₂Cl₂ as precursor gases and at a deposition temperature that is not less than 800 °C.

Preferably, the SiGe buffer layer is deposited on the surface of a silicon single crystal wafer or a SOI wafer (silicon on insulator).

The invention is further explained by referring to figures and examples.

### Brief description of the figures

**Fig. 1** schematically depicts the sample configuration used in a first set of experiments.
**Fig. 2** depicts the results of the first set of experiments.
**Fig. 3** schematically depicts the sample configuration used in a second set of experiments.
**Fig. 4** depicts the results of the second set of experiments.
**Fig. 5** depicts the results of an example.

### List of reference numerals employed

- **1**: substrate
- **2**: first silicon germanium buffer layer grown with a first growth rate
- **3**: second silicon germanium buffer layer grown with a second growth rate

### Example

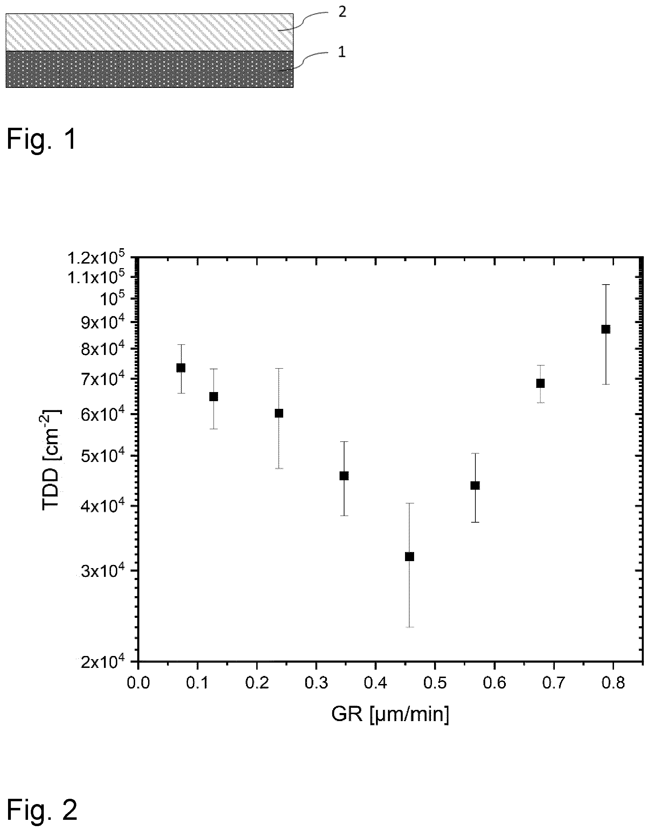

The growth rate influence on TDD in a first stage of buffer growth (nucleation phase) has been examined in a first set of experiments. The sample configuration used in the first set of experiments is depicted in Fig. 1.

A graded SiGe buffer layer 2 to a final concentration of 8% Ge was grown on a silicon single crystal wafer 1 (Fig. 1). The growth rate was varied from 0.05 µm/min to 0.8 µm/min and a grading rate of 4% Ge/µm has been used. The resulting TDD has been measured after defect selective etching. As shown in Fig. 2, which displays the TDD over the growth rate GR, the TDD decreases with increasing growth rate to a minimum at 0.46 µm/min.

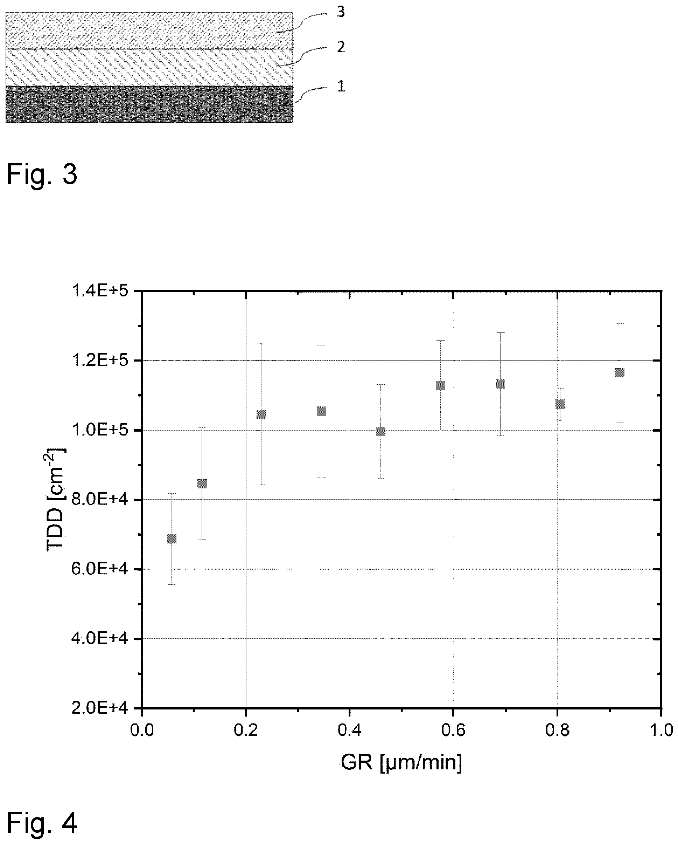

The growth rate influence in second stage of buffer growth (grading phase) has been examined in a second set of experiments. The sample configuration used in the second set of experiments is depicted in Fig. 3.

On top of a first SiGe buffer layer 2 with a Ge-concentration of 8%, a second graded buffer layer 3 was grown to a final concentration of 16% Ge. A grading rate of 4% Ge/µm has been used. The growth rate of the second layer 2 has been varied from 0.05 µm/min to 0.95 µm/min. From 0.05 µm/min to 0.23 µm/min the TDD increases, at higher growth rates the TDD stays constant. As shown in Fig. 4, the lowest TDD is realized at lower growth rates.

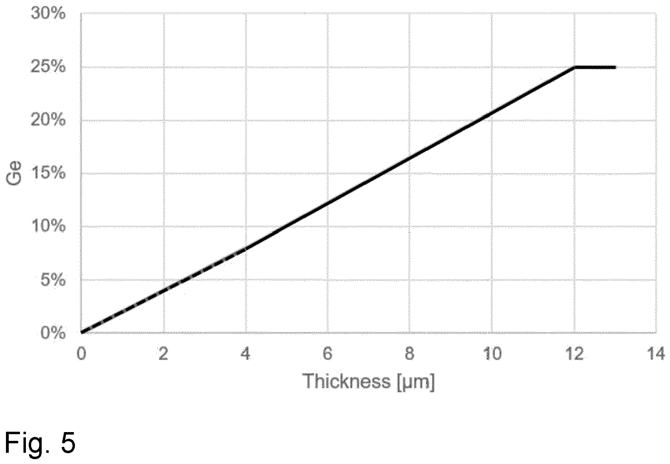

A full strain relaxed graded buffer layer up to a germanium content of 25% Ge has been deposited on a silicon single crystal wafer in accordance with the claimed invention (example). During the first stage of the deposition process, i.e. from the beginning of the process until a germanium content of 8 % Ge has been reached, the growth rate was 0.46 µm / min in accordance with the results of the first set of experiments and in order to generate a low base TDD within the base layer. For further grading up to the final content of 25% Ge the growth rate was 0.05 µm / min in accordance with the results of the second set of experiments. The overall grading rate was 2.1 % Ge / µm. As shown in Fig. 5 which depicts the content of germanium in the grown buffer layer over the thickness of the grown buffer layer, the final TDD achieved was 4 × 10⁴ / cm². The dotted line in Fig. 5 represents the first stage, the solid line the second stage of the deposition process.

The sets of experiments and the example have been performed in a commercial epitaxial reactor of type EPSILON 3200 manufactured by ASM at a deposition temperature of 1050 °C and with GeCl₄ and SiH₂Cl₂ as precursor gases.

## Claims

1. A method for depositing a strain relaxed graded buffer layer of silicon germanium on a surface of a substrate, the surface consisting of silicon and the buffer layer having an increasing content of germanium up to a final content, the method comprising
conducting GeCl₄ and SiH₂Cl₂ during a first and a second stage over the surface of the substrate at a deposition temperature of not less than 800 °C_{;}
growing the buffer layer with a grade rate that is less than 10 % Ge / µm; and
growing the buffer layer with a growth rate that is not less than 0.1 µm / min during the first stage and that is less than 0.1 µm / min during the second stage.

2. The method as claimed in claim 1, wherein the first stage ends not later than when 1/3 of the final content of germanium has been reached

3. The method as claimed in claim 1 or claim 2, wherein the final content of germanium is not less than 2 % Ge and not more than 90 % Ge.

4. The method as claimed in one of claims 1 to 3, wherein the buffer layer is deposited by chemical vapor deposition.

5. The method as claimed in one of claims 1 to 4, wherein the buffer layer is grown on a silicon single crystal wafer or on a SOI wafer.

## Patentansprüche

1. Verfahren zum Abscheiden einer spannungsrelaxierten abgestuften Pufferschicht aus Silicium-Germanium auf einer Oberfläche eines Substrats, wobei die Oberfläche aus Silicium besteht und die Pufferschicht einen zunehmenden Gehalt an Germanium bis zu einem Endgehalt aufweist, wobei das Verfahren Folgendes umfasst:
Leiten von GeCl₄ und SiH₂Cl₂ während einer ersten und einer zweiten Stufe über die Oberfläche des Substrats bei einer Abscheidungstemperatur von nicht weniger als 800 °C,
Wachsenlassen der Pufferschicht mit einer Abstufungsrate von weniger als 10 % Ge/µm und
Wachsenlassen der Pufferschicht mit einer Wachstumsrate von nicht weniger als 0,1 µm/min während der ersten Stufe und nicht weniger als 0,1 µm/min während der zweiten Stufe.

2. Verfahren nach Anspruch 1, wobei die erste Stufe nicht später endet als nach Erreichen von 1/3 des Endgehalts an Germanium.

3. Verfahren nach Anspruch 1 oder Anspruch 2, wobei der Endgehalt an Germanium nicht weniger als 2 % Ge und nicht mehr als 90 % Ge beträgt.

4. Verfahren nach einem der Ansprüche 1 bis 3, wobei die Pufferschicht durch chemische Gasphasenabscheidung abgeschieden wird.

5. Verfahren nach einem der Ansprüche 1 bis 4, wobei die Pufferschicht auf einem Siliciumeinkristallwafer oder auf einem SOI-Wafer wachsengelassen wird.

## Revendications

1. Procédé pour le dépôt d'une couche tampon à gradient à contrainte relâchée de silicium germanium sur une surface d'un substrat, la surface étant constituée de silicium et la couche tampon ayant une teneur en germanium qui augmente jusqu'à une teneur finale, le procédé comprenant
la conduite de GeCl₄ et SiH₂Cl₂ pendant un premier et un deuxième stade au-dessus de la surface du substrat à une température de dépôt non inférieure à 800 °C,
la croissance de la couche tampon avec un taux de gradient qui est inférieur à 10 % de Ge/um, et
la croissance de la couche tampon avec une vitesse de croissance qui n'est pas inférieure à 0,1 µm/min pendant le premier stade et qui est inférieure à 0,1 µm/min pendant le deuxième stade.

2. Procédé selon la revendication 1, le premier stade ne se terminant pas plus tard que lorsque 1/3 de la teneur totale de germanium a été atteinte.

3. Procédé selon la revendication 1 ou la revendication 2, la teneur finale de germanium n'étant pas inférieure à 2 % de Ge et n'étant pas supérieure à 90 % de Ge.

4. Procédé selon l'une des revendications 1 à 3, la couche tampon étant déposée par dépôt chimique en phase vapeur.

5. Procédé selon l'une des revendications 1 à 4, la couche tampon étant développée sur une plaquette monocristalline de silicium ou sur une plaquette SOI.
